# EUROPEAN PATENT APPLICATION

(11) **EP 0 845 545 A1**
(43) Date of publication of application: **03.06.1998**
(21) Application number: 97309447.7
(22) Date of filing: 24.11.1997
(51) Int. Cl.: C23C 14/34, H01J 37/34, H01L 21/285

(54) **Coated deposition chamber equipment**

(30) Priority: 26.11.1996 US 756468
(71) Applicant: Applied Materials, Inc., Santa Clara, California 95054 (US)
(72) Inventor: Ding, Peijun, San Jose, California 95129 (US); Yao, Gongda, Fremont, Califronia 94539 (US)
(74) Representative: Bayliss, Geoffrey Cyril

(57) **Abstract**

A coating (33) is applied to semiconductor device fabrication equipment (15), specifically to any surface within a deposition chamber. Characteristics of the coating promote adhesion of a layer (29) deposited thereon, and reduce stress between the equipment surface and the deposited layer. The coating therefore reduces the probability of deposited layers (29) peeling off deposition equipment and contaminating the substrate. In one aspect, the equipment surface (39) is roughened prior to application of the coating(33).

## Description

The present invention relates to apparatuses and methods for the fabrication of semiconductor devices. More particularly, the present invention relates to sputter deposition of material layers over substrates having holes, trenches or steps in the upper surface, wherein the deposition layer conformally covers the substrate surface and exhibits substantially uniform thickness along the base and sidewalls of holes, trenches and steps (i.e., surface features), and along the entire substrate surface.

Sputtering is one well-known method of depositing a material layer on a semiconductor substrate. A typical sputtering apparatus includes a target and a substrate support pedestal enclosed in a vacuum chamber. The target is typically affixed to the top of the chamber, but is electrically isolated from the chamber walls. A voltage source maintains the target at a negative voltage with respect to the walls of the chamber, creating a voltage differential which excites a gas contained within the vacuum chamber into a plasma. Plasma ions are generated and directed to the target where plasma ion momentum transfers to target atoms, causing the target atoms to be ejected (i.e., to sputter). The sputtered target atoms deposit on the substrate, thereby forming a thin film. Preferably, the thin film must be of substantially uniform thickness.

Ideally, the thickness of the deposited film should exhibit substantially uniform thickness along the base and side walls of surface features (such as trenches, holes, vias or other apertures) and across the entire substrate surface (also known as the field).

One limit on the ability to provide a uniform thickness film is in the inherent geometric limits of sputtering. Because surface features typically extend into the surface of the substrate (e.g., a via in a dielectric layer), the adjacent field surface shades or blocks the feature surfaces, leading to thinner deposition on the feature surfaces than on the field. Target atoms traveling in paths substantially non- perpendicular to the substrate deposit on the field and not on the base or lower sidewall of the feature.

In order to increase the thickness of the film layer on the base of surface features such as vias, one or more particle screening devices (such as a plate or collimator) may be employed between the target and substrate. Such a screening device is designed to block target particles traveling in paths which are substantially non-perpendicular to the substrate's upper surface. The non-perpendicularly traveling particles collide with, and deposit on, the surface of the particle screening device. Most particles traveling perpendicular to the substrate pass through the particle screening device, yielding a thick film layer at the base of the feature. An additional screening device is a tube, or plurality of nested, thin-walled tubes, located between the target and substrate, wherein the diameter of the tubes is substantially greater than the feature diameter. These tubes prevent particles from one edge of the target from reaching the portion of the substrate located diametrically opposed therefrom, thereby effectively establishing zones on the target which provide deposition material to specific regions of the substrate. By properly sizing and locating the tube vis a vis the target and substrate, a more uniform thickness deposition layer will result. As sputtering continues, the particles deposited on the surface of the particle screening device may peel off, falling onto and contaminating the substrate. Although particles may peel off any portion of the screening device, target particles which deposit on the lower portion of the screening device are particularly likely to peel off due to the relatively low energy with which they impact the screening device.

A conventional method for reducing the number of substrates contaminated due to peeling off from the screening device includes periodically etching the particle screening device to remove target material buildup. Such periodic etching causes increased chamber downtime, reducing throughput and increasing maintenance costs. Further, etching requires additional auxiliary equipment which increases the overall system cost. In an effort to avoid the chamber downtime associated with periodic etching of the particle screening device, the practice of inverting the particle screening device has been implemented, such that the lower end or bottom of the device becomes the upper end or top of the device and vice versa. When the lower and upper surfaces of the screening device are switched, a relatively continuous, highly adhered film is formed on the surface of the screening device facing the target, thereby locking any loose particles deposited thereon when the surface faced the substrate.

The screening device must be repeatedly inverted after one or more substrates are processed within the deposition chamber. Although rotation of the screening device requires less chamber downtime than does etching the screening device, substantial chamber downtime results from the repeated rotation of the screening device. Further, particles may become dislodged from the screening device as it is rotated. Alternatively, rather than rotating the screening device, the screening device may be periodically replaced. However, replacing the screening device also causes downtime, and increases wafer costs.

Unfortunately, although conventional methods for reducing peeling off reduce the frequency of peeling of particles from the screening device, peeling off remains a significant cause of substrate contamination. As well, conventional methods for reducing peeling off require chamber downtime, thereby decreasing wafer throughput and driving up wafer cost.

Thus, a need exists in the semiconductor fabrication field for a method and apparatus that will further reduce the frequency of substrate contamination due to peeling off, without reducing productivity or increasing wafer cost.

Accordingly, it is an object of the present invention to reduce the occurrence of contaminated wafers caused by target material peeling off deposition chamber equipment. It is a further object of the present invention to eliminate the need for mid-target life etch of the screening device, and to eliminate the need for rotation of particle screening devices, thereby increasing throughput and reducing device costs.

In the present invention, a coating is applied to the surface of equipment used in semiconductor fabrication to deposit thin films. The coating advantageously forms a bridge between the equipment surface and the deposited layer formed by particles of the depositing material which impact the deposition equipment.

Characteristics of the coating promote adhesion between the coating and the depositing particles which impact the coating. Likewise, characteristics of the coating promote adhesion between the coating and the surface of the deposition equipment. Specifically, in one aspect of the invention, the coating is of low density, has a rough surface and has a random grain structure, such that grain boundaries are oriented more parallel to the interface between the equipment surface and the coating than are the grain boundaries of the deposited layer.

By employing a coating having one or more of the above characteristics, the invention greatly reduces the number of wafers contaminated due to deposited material peeling off deposition equipment surfaces.

In one aspect of the invention, the coating is applied only to the portion of the screening device facing the substrate.

In another aspect of the invention, the surface of the particle screening device is roughened prior to application of the coating, thereby further increasing adhesion between the surface of the particle screening device and the coating.

In a further aspect of the invention, the coating is comprised of target material, thus eliminating the thermal stress which occurs when two materials, each having a different thermal coefficient of expansion, undergo the successive heating and cooling required of semiconductor device fabrication equipment.

The following is a description of some specific embodiments of the invention, reference being made to the accompanying drawings, in which:
FIG. 1 is a diagrammatic illustration, in section, of the essential portions of a sputtering chamber for employing the present invention, including a particle screening device;
FIG. 2 is a partial sectional view of the particle screening device of FIG. 1, having a deposited layer formed thereon;
FIG. 3 is a partial sectional view of a particle screening device made in accordance with the present invention, having a deposited layer formed thereon; and
FIG. 4 is a partial sectional view of a particle screening device made in accordance with the present invention, wherein the surface of the particle screening device is roughened prior to application of the coating.

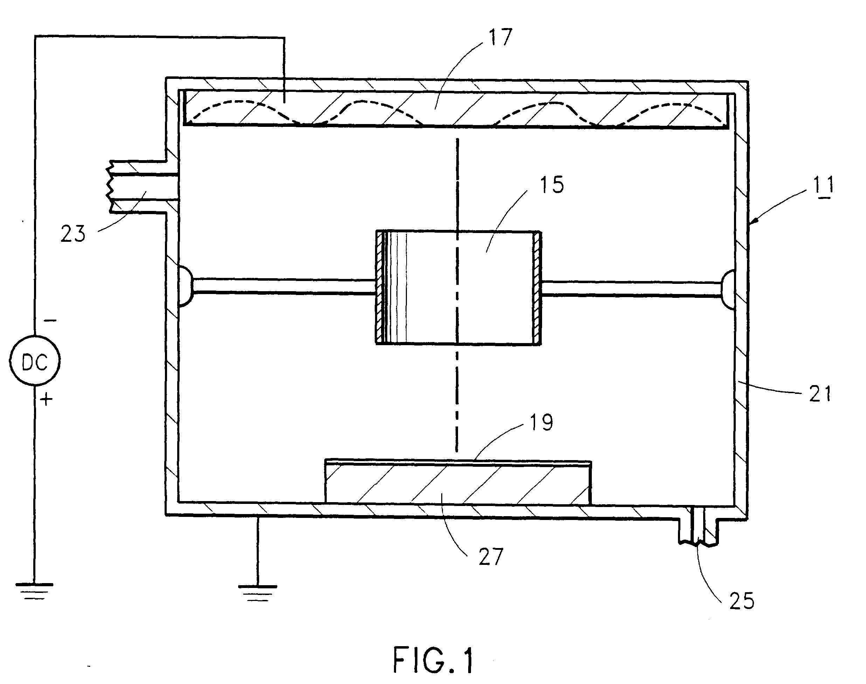

FIG. 1 is a diagrammatic illustration, in section, of the essential portions of a sputtering chamber 11 for employing the present invention. Sputtering chamber 11 has a particle screening device 15 positioned between a sputtering target 17 and a semiconductor substrate 19. As shown in FIG. 1, in one aspect of the invention the particle screening device 15 is a cylindrical tube which blocks obliquely traveling particles (i.e., undesirable particles) from reaching semiconductor substrate 19, as described in U.S. Patent No. 5,527,438 by Avi Tepman et al., the disclosure of which is hereby incorporated by reference.

The sputtering chamber 11 for practicing our invention generally includes a vacuum chamber enclosure wall 21 having at least one gas inlet 23 and an exhaust outlet 25 connected to an exhaust pump (not shown). A substrate support pedestal 27 is disposed at the lower end of chamber 11, and sputtering target 17 is mounted to the upper end of chamber 11. Target 17 is electrically isolated from enclosure wall 21. Enclosure wall 21 is preferably grounded so that a negative voltage may be maintained on target 17 with respect to grounded enclosure wall 21. In operation, substrate 19 is positioned on support pedestal 27.

During the deposition process, a gas (typically a non-reactive species such as Ar) is charged into sputtering chamber 11 through gas inlet 23 at a selected flow rate regulated by a mass flow controller. The chamber pressure is controlled by throttling the rate at which chamber gases are pumped through exhaust outlet 25.

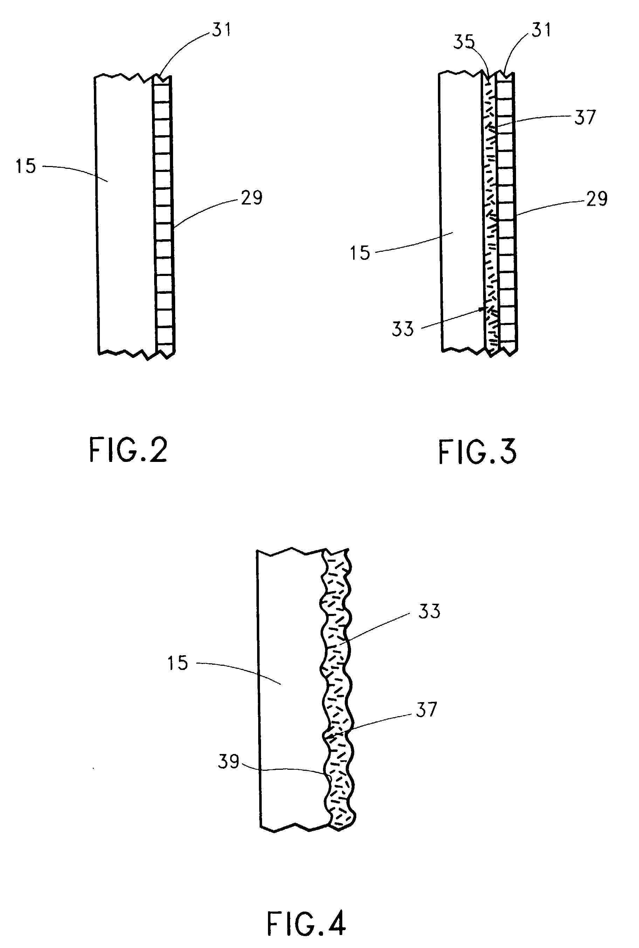

A D.C. power supply applies a negative voltage to target 17 with respect to enclosure wall 21 so as to excite the chamber gas into a plasma state. A conventional magnetron sputtering source employs a magnet (not shown) above target 17 to increase the concentration of plasma ions adjacent to the sputtering surface of target 17. Ions from the plasma bombard target 17 and sputter atoms and larger particles of target material from target 17. The particles sputtered from target 17 travel along linear trajectories from target 17, and a portion of the particles collide with, and deposit on, both substrate 19 and particle screening device 15, as well as on other equipment surfaces. Thus, a deposited layer 29 (see, FIG. 2) is formed on particle screening device 15.

FIG. 2 is a partial sectional view of a particle screening device 15, having deposited layer 29 formed thereon. Because deposited layer 29 formed on particle screening device 15 is sputter deposited under high temperature conditions, deposited layer 29 is a dense, high reflectivity layer, having a first grain structure 31 oriented substantially normal (i.e., perpendicular) to the surface of particle screening device 15.

Typical deposition processes take place at high temperatures (about 200°C - 500°C). In addition to auxiliary heating, deposition equipment is inherently heated by the sputtering process itself (due to high energy electrons impacting the surface of deposition equipment and the condensation heat of deposited layers formed on equipment surfaces).

When sputtering ceases, sputtering chamber 11, particle screening device 15 and any other deposition equipment within chamber 11 begin to cool. As particle screening device 15 and deposited layer 29 cool, they contract at different rates due to the different thermal coefficients of expansion of the particle screening device material (e.g., titanium, stainless steel, copper, etc.) and the deposited layer (e.g., aluminum, titanium, titanium nitride, etc.).

Likewise, as sputtering resumes and particle screening device 15 and deposited layer 29 reheat, they expand at different rates. This difference in contraction and expansion rates causes thermal stress. As a result of thermal stress, deposited layer 29, which is not strongly adhered to particle screening device 15 (e.g., due to mismatch between the grain structures of deposited layer 29 and particle screening device 15, and/or due to low impact energies), peels off particle screening device 15 and contaminates substrate 19. Although deposited layer 29 may peel off any portion of particle screening device 15, the lower portion of deposited layer 29 is more susceptible to cracking and peeling off. Because fewer particles impact the lower portion of particle screening device 15, the lower portion of deposited layer 29 is relatively thin or discontinuous and is therefore more likely to peel off.

FIG. 3 is a partial sectional view of particle screening device 15 made in accordance with the present invention, having deposited layer 29 formed thereon. As shown, a coating 33 adheres to the surface of particle screening device 15. In a preferred embodiment, coating 33 is a porous layer, having a second grain structure 35 more parallel to the surface of particle screening device 15 than first grain structure 31 of deposited layer 29, and having a rough or non-uniform surface 37. In order to achieve these characteristics, coating 33 may be applied via conventional methods (such as flame spraying, arc spraying, plasma spraying, etc.) known to those of ordinary skill in the art. Further, coating 33 comprises a material having a thermal coefficient of expansion similar to that of deposited layer 29. In a preferred embodiment, coating 33 comprises the same material as the target material; for example, if the target material is aluminum, coating 33 will be flame sprayed aluminum or will be a flame sprayed composite material which contains aluminum.

The porosity of coating 33 allows atoms within coating 33 to reposition easily, thereby relieving thermal stress which results as particle screening device 15 and coating 33 expand and contract at different rates due to the difference (i.e., mismatch) in coefficients of thermal expansion between the material of particle screening device 15 (e.g., titanium) and the material of coating 33 (e.g., aluminum). The reduction in thermal stress increases adhesion of coating 33 to particle screening device 15 and reduces the probability of cracking of coating 33. The roughness or non-uniformity of coating 33 provides increased contact area between coating 33 and deposited layer 29, thereby increasing adhesion between coating 33 and deposited layer 29. The second grain structure 35 (of coating 33) is oriented more parallel (i.e., more parallel than the first grain structure 31 of deposited layer 29) to the interface between particle screening device 15 and coating 33, and thereby reduces intrinsic stress between particle screening device 15 and deposited layer 29 which results due to lattice mismatch. In this manner coating 33 increases adhesion and further reduces the probability that coating 33 or deposited layer 29 will peel off. Thus, the density, non-uniformity and/or more parallel grain structure of coating 33 is of a degree sufficient to reduce the frequency of peeling off which occurs in the absence of coating 33. Further, second grain structure 35 is sufficiently random or sufficiently more parallel to the interface between particle screening device 15 and coating 33, so as to increase adhesion therebetween. Preferably, coating 33 is aluminum and has a density between 2.5 and 2.7 grams/cm³ (approximately five percent less than the standard density of aluminum).

FIG. 4 is a partial sectional view of particle screening device 15 made in accordance with a further aspect of the present invention, wherein a surface 39 of particle screening device 15 is roughened via bead blasting (or other conventional methods known to those of ordinary skill in the art) prior to application of coating 33. The roughness of surface 39 provides increased contact area and therefore increased adhesion between particle screening device 15 and coating 33. Preferably, coating 33 conformally covers surface 39. Thus, by roughening surface 39, the roughness or non-uniformity of rough surface 37 also increases. Accordingly, deposited layer 29 adheres more strongly to coating 33 and the number of wafers contaminated by peeling off is further reduced.

With use of the present invention, 900 KwH of sputtering (a measure of target erosion) can occur without a single wafer being contaminated by peeling off, while prior art methods exhibit peeling off at least as early as 600 KwH. Accordingly, the present invention greatly reduces the number of wafers contaminated due to peeling off. Further, the present invention eliminates the need for mid-target life, changing, etching and/or rotation of deposition equipment, thereby increasing throughput and reducing wafer costs.

Now that the preferred embodiments of the present invention have been shown and described in detail, various modifications and improvements thereon will become readily apparent to those skilled in the art. For instance, although the apparatus of the present invention has been described primarily as a particle screening device, any surface within a deposition chamber may benefit from use of the present invention. Further, although the invention has been described with reference to sputter deposition of aluminum, it applies equally as well to other methods of deposition and to alternative deposition materials. Accordingly, while the present invention has been disclosed in connection with the preferred embodiments thereof, it should be understood that there may be other embodiments which fall within the spirit and scope of the invention, as defined by the following claims:

## Claims

1. A device for use in depositing layers during semiconductor fabrication, comprising:
a device surface, having a first thermal coefficient of expansion; and
a coating on a portion of said device surface;
said coating having a second thermal coefficient of expansion; and
said coating being sufficiently porous to compensate for mismatch between the first thermal coefficient of expansion and the second thermal coefficient of expansion which will occur as the temperature thereof changes.

2. The device of Claim 1 wherein a surface of said coating is non-uniform.

3. The device of Claim 1 wherein a surface of said coating in contact with said device surface has a random grain structure oriented more parallel than normal to said device surface.

4. The device of Claim 1 wherein a surface of said coating in contact with said device surface has a grain structure oriented more parallel than normal to said device surface.

5. The device of Claim 4 wherein the grain structure is oriented substantially parallel to the device surface.

6. The device of Claim 1 wherein said device comprises a particle screening device.

7. The device of Claim 1 wherein said coating and a deposition layer formed thereon comprise the same material.

8. The device of Claim 7 wherein said coating is a composite material.

9. A device for use in depositing layers during semiconductor fabrication, comprising:
a device surface; and
a coating on a portion of said device surface;
said coating having a non-uniform surface so as to promote adhesion between said coating and a deposition layer deposited on said coating.

10. The device of Claim 9 wherein a surface of said coating in contact with said device surface has a random grain structure.

11. The device of Claim 9 wherein said coating and the deposition layer comprise the same material.

12. The device of Claim 9 wherein said device comprises a particle screening device.

13. A device for use in depositing layers during semiconductor fabrication, comprising:
a device surface;
a coating on a portion of said device surface; and
an interface between said device surface and said coating;
said interface comprising said device surface and a surface of said coating, wherein the surface of said coating has a grain structure oriented more parallel than normal to said device surface.

14. The device of Claim 13 wherein said coating and a deposition layer deposited thereon comprise the same material.

15. The device of Claim 13 wherein said device comprises a particle screening device.

16. The device of Claim 15 wherein said device comprises a tube shaped collimator and wherein the portion comprises a lower portion of said collimator.

17. A device for sputter depositing a film on a substrate, comprising:
a chamber enclosing a substrate support member;
a sputtering target comprising a target material;
means for sputtering said sputtering target;
a particle screening device located between said sputtering target and the substrate support member for screening undesirable target particles, said particle screening device comprising:
a device surface; and
a coating comprising the target material, said coating forming a bridge between said device surface and the undesirable target particles, thereby reducing peeling of the undesirable target particles.

18. The device of Claim 17 wherein said coating is sufficiently porous to compensate for mismatch between a thermal coefficient of expansion of said device surface, and a thermal coefficient of expansion of said coating.

19. The device of Claim 17 wherein a surface of said coating is non-uniform.

20. The device of Claim 17 wherein said coating has a random grain structure.

21. The device of Claim 18 wherein said coating has a grain structure oriented more parallel to said device surface than is a grain structure of a deposition layer deposited thereon.

22. The device of Claim 17 wherein said device surface is rough.

23. A method of depositing a target material layer on a substrate comprising the steps of:
providing a sputter deposition chamber having at least a target and a substrate therein;
spacing the target a long throw distance from the substrate;
sputtering the target to provide a flux of target particles for deposition on the substrate; and
placing a particle screening device between the substrate and the target, the particle screening device having a porous coating comprising target material on a surface thereof.

24. The method of Claim 23 wherein the coating has a non-uniform surface and a random grain structure.

25. A method of coating a surface of equipment for use in depositing layers during semiconductor fabrication, comprising the step of:
applying a material coating to the deposition equipment surface, the material coating being sufficiently porous to compensate for mismatch between a thermal coefficient of expansion of the deposition equipment surface and a thermal coefficient of expansion of the material coating.

26. The method of Claim 25 wherein the material coating has a random grain structure and has a rough surface so as to promote adhesion of particles impacting the material coating.

27. The method of Claim 25 further comprising roughening the deposition equipment surface prior to applying the material coating.

28. The method of Claim 25 further comprising bead blasting the deposition equipment surface prior to applying the material coating.
